# EUROPEAN PATENT APPLICATION

(11) **EP 3 686 922 A1**
(43) Date of publication of application: **29.07.2020**
(21) Application number: 18859037.6
(22) Date of filing: 30.08.2018
(51) Int. Cl.: H01L 21/683, H02N 13/00

(54) **WAFER SUPPORTING DEVICE**

(30) Priority: 19.09.2017 JP 2017179339
(71) Applicant: MOMENTIVE QUARTZ JAPAN G.K., Minato-ku Tokyo 1076112 (JP)
(72) Inventor: MORIKAWA Yuji, Sayo-gun Hyogo 679-5641 (JP)
(74) Representative: Potter Clarkson
(86) International application number: PCT/JP2018/032134
(87) International publication number: WO 2019/058918

(57) **Abstract**

[Problem] To provide a wafer supporting device wherein particle generation is suppressed while chucking force is not decreased. [Solution] In this wafer supporting device, chuck electrodes 3 are provided in a predetermined pattern on the surface of an insulation base material, the chuck electrodes being covered by an insulation cover layer 5 made up of PBN or C-PBN. The surface of each chuck electrode has a protruding section 3a so as to assume a protruding-and-recessed shape. The surface of the insulation cover layer is formed into a protruding-and-recessed shape in conformity with the protrusions and recesses of the chuck electrode surfaces. The top surfaces of the protruding sections 5a of the insulation cover layer are approximately flush with one another, forming a wafer placement face 9.

## Description

### Field of Invention

The present invention relates to a wafer supporting device for use in a manufacturing process of semiconductor and liquid crystal.

### Background Art

In a manufacturing process of semiconductor and liquid crystal, an electrostatic chuck has been widely used as a device for fixing a wafer in dry etching or PVD (physical vapor deposition).

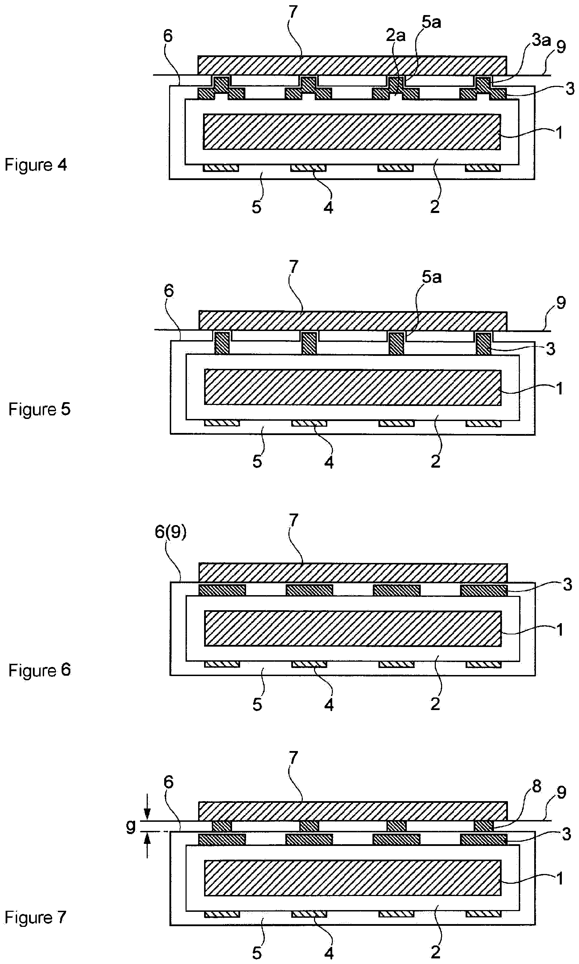

The prior art electrostatic chuck has been designed as shown in Fig.6, wherein a conductive electrode 3 for electrostatic chucking is arranged in a predetermined pattern on a top surface of an insulation substrate having a graphite plate 1 covered by an insulation layer 2 made from pyrolytic boron nitride (PBN), for example, and another conductive electrode 4 for heating is arranged in a predetermined pattern on a bottom surface of the insulation substrate, both electrodes 3, 4 being covered by an insulation cover layer 5. Though not shown, the opposite ends of the electrodes 3, 4 are connected to a power source via terminals.

With the above-designed electrostatic chuck, a work 7 such as a wafer to be electrostatically chucked is placed on a wafer supporting plane 9 that is a top surface 6 of the insulation cover layer 5, and a voltage is applied between the terminals of the electrode 3 to generate a Coulomb force, which will electrostatically chuck the work 7. The construction of Fig.6 also has the heater electrode 4, which makes it possible to chuck the work 7 while uniformly heating the work 7 to an optimal temperature for creating a desired chucking force.

Fig. shows an example of the bipolar electrostatic chuck design. A unipolar electrostatic chuck is designed such that a single conductive electrode (chuck electrode 3) is arranged on an insulation substrate, which is covered by an insulation cover layer 5. A voltage is applied between the chuck electrode 3 and a work 7 placed on a top surface 6 of the insulation cover layer 5 to chuck the work 7.

The insulation cover layer 5 should preferably have electrical resistance ranging 10⁸-10¹³Ω • cm. The insulation cover layer 5 having electrical resistance lying in this range will allow a very small current to flow between the electrode and the work and drastically increase the chucking force through the Johnson-Rahbeck effect.

From this point of view, the present applicant have proposed the method for obtaining the electronical resistance laying in the above range by forming an insulation cover layer 5 comprising C-PBN which is produced by incorporating a feeble amount of carbon into PBN through CVD (chemical vapor deposition), see Patent Document 1. More specifically, a reaction gas (boron trichloride and ammonia, for example) for PBN formation mixed with another gas (methane, for example) necessary for carbon incorporation is introduced into a reduced-pressure, high-temperature CVD furnace, to thereby form the insulation cover layer 5 comprising a PBN product containing a feeble amount of carbon.

The electrostatic chuck having the insulation cover layer 5 comprising PBN (including C-PBN with a feeble carbon content, the same shall also apply hereinafter) has been found to provide almost satisfactory property. However, PBN has a laminated crystal structure and, therefore, PBN crystals could be separated from the PBN insulation cover layer 5 to generate particles or dust, which could be deposited onto the bottom surface of the wafer to significantly lower its product value.

The inventor has carried out experiments regarding this problem and confirmed that many particles are deposited on the chuck electrode pattern of the electrostatic chuck. It can be derived from this finding that when the work 7 such as a wafer placed directly on the top surface 6 of the insulation cover layer 5 is chucked onto the chuck electrode 3, it would scratch the top surface 6 that comprises soft PBN material, thereby generating particles.

In order to solve the defects and disadvantages of the above-described prior art to thereby provide a wafer supporting device capable of preventing the particle generation, the present applicant has carried out repeatedly studies and experiments and then proposed a novel chuck design in Patent Document 2. More specifically, as a variation or improvement from the chuck design of Fig.6, the new proposal is such as shown in Fig.7, wherein partial projections 8 comprising PG, which is a material harder than PBN, are formed on the top surface 6 of the PBN insulation cover layer 5 by embossing, for example, so that the top surfaces of the projections 8 define a wafer supporting plane. With this design, the wafer 7 is in no contact with the top surface of the PBN insulation cover layer 5 but supported on the projections 8 made of PG that is harder material than PBN. A decreased contact area will greatly reduce the particle generation and effectively prevent a deterioration of its product value which could be caused by particles deposited on the bottom surface of the wafer.

### Prior Arts

### Patent Documents

Patent Document 1: Japan Patent No.2756944
Patent Document 2: Japan Patent Publication No.2017-034042(A)

### Summary of Invention

### Problems to be Solved by Invention

However, when the chuck is so designed as shown in Fig.7, the wafer 7 supported on the top surface (the wafer supporting plane) of the PG projections 8 is moved away from the chuck electrode 3 by a distance corresponding to the height of the PG projections 8, when compared with the design of Fig.6. This will decrease the chucking force. The chucking force F by the electrostatic chuck decreases as the gap (g) between the chuck electrode 3 and the work (wafer 7) becomes larger. The design of Fig.7 provides a larger gap (b) because of the height of the PG projections 8 and, therefore, provides a decreased chucking force F. When the wafer 7 is supported on the wafer supporting plane that is horizontal, decrease of the chucking force F caused by the PG projections 8 may be negligible in practice and provide a sufficient chucking force. However, when it is necessary to vertically chuck the wafer, the wafer 7 cannot be held and should fall down.

Accordingly, the problem to be solved by the present invention is to provide a wafer supporting device capable of preventing the particles generation, while minimizing the chucking force decrease

### Means for Solving the Problems

According to claim 1 of the present invention, there is provided a wafer supporting device wherein a chuck electrode is formed in a predetermined pattern on a surface of an insulation substrate and said chuck electrode is covered by an insulation cover layer made of PBN or C-PBN, characterized in that said insulation cover layer has an uneven surface with projections covering projections of said chuck electrode, top surfaces of said projections being formed flush with each other to define a wafer supporting plane.

According to claim 2 of the present invention, in the wafer supporting device of claim 1, it is characterized in that said chuck electrode has an uneven surface, and said uneven surface of said insulation cover layer is formed in correspondence with said uneven surface of said chuck electrode pattern.

According to claim 3 of the present invention, in the wafer supporting device of claim 1, it is characterized in that a plurality of projections are formed in a dotted pattern with gaps therebetween on the surface of said chuck electrode.

### Advantages of Invention

In accordance with the present invention, the wafer is not in contact with the entire surface of the PBN (including C-PBN, the same shall also apply hereinafter) insulation cover layer but supported on the projections formed in a dotted, linear or latticed pattern on the said surface. Consequently, as compared with the prior art shown in Fig.6, the contact area between the wafer and the PBN insulation cover layer is greatly reduced, which will significantly reduce the particle generation and effectively prevent deterioration of its product value which could be caused by the particles deposited on the bottom surface of the wafer.

In addition, the projections formed on the surface of the PBN insulation cover layer will cover at least a part of the chuck electrode pattern, which will prevent the wafers from being positioned apart from the chuck electrode, which has been seen in the prior art shown in Fig.7, and therefore prevent or effectively suppress lowering of the chucking force.

Thus, in accordance with the present invention, it is possible to provide a wafer supporting device capable of preventing generation of the particle generation, while minimizing the chucking force decrease

### Brief Description of Drawings

[Fig.1] a cross-section of an electrostatic chuck according to an embodiment (Embodiment 1) of the present invention.
[Fig.2] a partial plan view of this electrostatic chuck.
[Fig.3] a cross-section of an electrostatic chuck according to another embodiment (Embodiment 2) of the present invention.
[Fig.4] a cross-section of an electrostatic chuck according to still another embodiment (Embodiment 3) of the present invention.
[Fig.5] a cross-section of an electrostatic chuck according to still another embodiment (Embodiment 4) of the present invention.
[Fig.6] a cross-section of an electrostatic chuck according to the prior art (shown in Fig.2 of Patent Document 2).
[Fig.7] a cross-section of an electrostatic chuck according to the prior art (shown in Fig.1 of Patent Document 2).

### Embodiments of Invention

The present invention will be described in detail in reference to some embodiments thereof.

### Embodiment 1

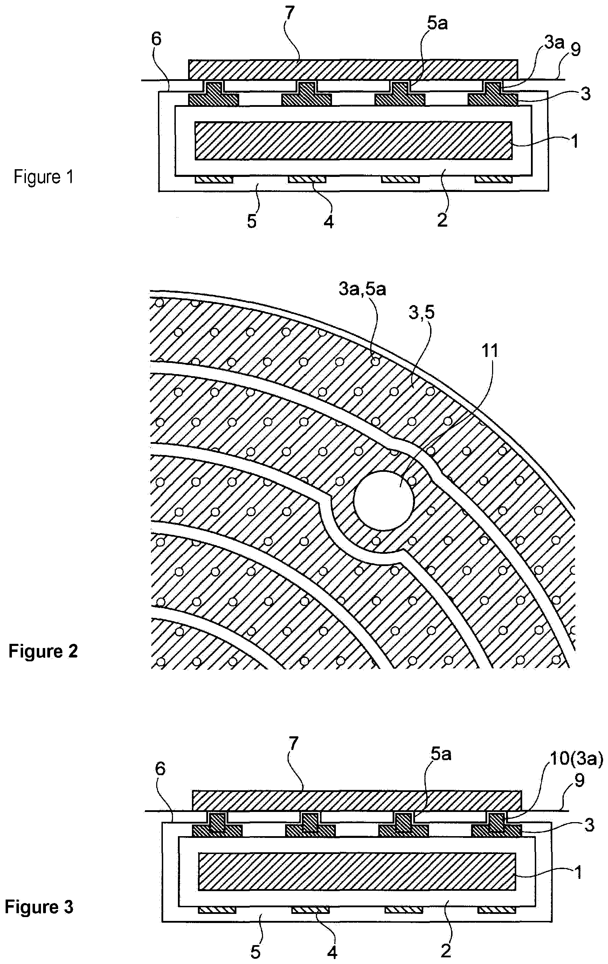

Fig. 1 is a cross-section showing an electrostatic chuck according to an embodiment (Embodiment 1) of the present invention. This electrostatic chuck is so designed that a conductive electrode 3 for electrostatic chucking is arranged in a predetermined pattern on a top surface of an insulation substrate having a graphite plate 1 covered by an insulation layer 2 made from pyrolytic boron nitride (PBN), for example, and another conductive electrode 4 for heating is arranged in a predetermined pattern on a bottom surface of the insulation substrate, both electrodes 3, 4 being covered by an insulation cover layer 5. Though not shown, the opposite ends of the electrodes 3, 4 are connected to a power source via terminals. Basically, this electrostatic chuck has the same design and function as the afore-mentioned prior art electrostatic chuck (Fig.6, Fig.7).

However, in this electrostatic chuck, as shown also in Fig.2, the chuck electrode 3 has an uneven surface wherein a plurality of surface projections 3a having a circular shape in a plan view are dotted in its pattern, and the insulation cover layer 5 also has an uneven surface which substantially corresponds to the uneven surface of the chuck electrode 3. The surface projections 5a of the insulation cover layer 5 covering the surface projections 3a of the chuck electrode 3 are formed to have the same height, and the surface projections 5a define a wafer supporting plane 9. The reference numeral 11 in Fig.2 denotes a terminal hole. A current from an external power source is supplied to the chuck electrode 3 via a terminal (not shown) inserted into the terminal hole 11.

In the prior art shown in Fig.7, the chuck electrode 3 is formed as a flat plate having the same height over the entire areas of the predetermined pattern, which should lower the chucking force due to a gap (g) corresponding to the height of the PG projections 8 over the entire areas. On the contrary, according to this embodiment, the gap will be minimized at least above the surface projections 3a of the chuck electrode, which makes it possible to minimize the chucking force decrease.

In addition, the projections 5a of the uneven insulation cover layer 5 have the top surfaces which are formed flush with each other to define the supporting place 9 for the wafer 7. Accordingly, it is possible to significantly reduce the particle generation because of the reduced contact area, which is the same advantage as that achievable by the prior art shown in Fig.7. It is possible to prevent or greatly reduce the particle generation even used in a high-temperature condition.

By way of example, the electrostatic chuck of Fig.1 can be produced in the following manner.

A 300-micrometer thick PBN insulation layer 2 is formed by a thermal CVD process to cover the entire surface areas of a 10mm thick disc-shaped graphite plate 1. After a PG layer is formed by a thermal CVD process to cover the top and bottom surfaces thereof, a part of the top surface thereof is removed to form a predetermined pattern of a chuck electrode 3. Likewise, a part of the bottom surface thereof is removed to form a predetermined pattern of a heater electrode 4. The chuck electrode 3 thus formed on the top surface provides an uneven surface wherein a plurality of columnar projections 3a are dotted in the pattern with every center-to-center distance of 3mm. Such uneven surface can be formed by using mechanical technique such as embossing, chemical technique such as etching, or any other known technique.

Then, 3 mol of ammonia gas and 2.4 mol of methane gas are mixed with 1 mol of boron trichloride, which is reacted in a thermal CVD furnace at 0.5 Torr and 1850 degrees Celsius to form a carbon-incorporated PBN (C-PBN) insulation cover layer 5 covering the entire surface areas of the PBN insulation layer 2 having the electrodes 3, 4, thereby producing the electrostatic chuck of Fig.1. Above the chuck electrode 3 having the uneven surface, the insulation cover layer 5 is formed to have an uneven surface corresponding to the uneven surface of the chuck electrode, so that the columnar projections 5a of the insulation cover layer 5 are formed above the projections 3a in a dotted pattern, and the top surfaces of the projections 5a are flush with each other to define a wafer supporting plane 9.

In accordance with this design, the wafer 7 is supported on the projections 5a of the insulation cover layer 5 (the wafer supporting plane 9), so that the contact area with the PBN or C-PBN insulation cover layer 5 becomes smaller, which will suppress the particle generation. In addition, the projections 5a of the insulation cover layer 5 are formed just above the projections 3a of the chuck electrode 3, so that the wafer 7 supported on the projections 5 (the wafer supporting plane 9) is positioned in close vicinity onto the electrode projections 3a with a very thin film of the insulation cover layer 5 therebetween. Accordingly, the gap (g) in the prior art design of Fig.7 can be reduced to almost zero (g=0) in the electrostatic chuck of Fig.1 at least between the wafer and the electrode projections 3a, which will minimize the chucking force decrease.

### Embodiment 2

Fig.3 is a cross-section showing an electrostatic chuck according to another embodiment (Embodiment 2) of the present invention. This electrostatic chuck employs another manner for forming the projections 3a in a pattern of the chuck electrode 3, which is different from the electrostatic chuck of Fig.1. More specifically, in this electrostatic chuck, a plurality of stud insertion holes (with no reference numeral) are formed in a dotted manner into a predetermined depth from the surface of the chuck electrode 3 formed on the surface of the insulation layer 2 in a predetermined pattern, and rod-like studs made of material (PG) identical to the chuck electrode 3 are inserted into the respective stud inserting holes in such manner that their leading ends protrude from the chuck electrode 3 to form projections 3a.

Except for the above-described features, this electrostatic chuck has the same design and function as the electrostatic chuck of Fig.1, so that the common members and elements are denoted by the same reference numerals and their detailed explanation is omitted.

### Embodiment 3

Fig.4 is a cross-section showing an electrostatic chuck according to still another embodiment (Embodiment 3) of the present invention. This electrostatic chuck employs still another manner for forming the projections 3a in a pattern of the chuck electrode 3, which is different from the electrostatic chuck of Fig.1. More specifically, in this electrostatic chuck, a plurality of dotted projections 2a are formed on the surface of the insulation cover layer 2 corresponding to the pattern of the chuck electrode 3, and the chuck electrode 3 is formed to cover the projections 2a, whereby the projections 3a are formed above the projections 2a.

Except for the above-described features, this electrostatic chuck has the same design and function as the electrostatic chuck of Fig.1, so that the common members and elements are denoted by the same reference numerals and their detailed explanation is omitted.

### Embodiment 4

Fig.5 is a cross-section showing an electrostatic chuck according to still another embodiment (Embodiment 4) of the present invention. This electrostatic chuck employs another manner for forming the projections 5a of the insulation cover layer 5, which is different from the electrostatic chuck of Fig.1. More specifically, in this electrostatic chuck, when forming a predetermined pattern of the chuck electrode 3 on the surface of the insulation layer 2, its height is made greater than the film thickness of the insulation cover layer 5 to be formed thereafter, so that the insulation cover layer 5 will protrude above along the top of the electrode to form the projections 5a that protrude above from the remaining surface areas of the insulation cover layer..

Except for the above-described features, this electrostatic chuck has the same design and function as the electrostatic chuck of Fig.1, so that the common members and elements are denoted by the same reference numerals and their detailed explanation is omitted.

### Legends

- 1: graphite plate
- 2: insulation layer
- 2a: projection
- 3: chuck electrode
- 3a: projection
- 4: heater electrode
- 5: insulation cover layer (PBN or C-PBN)
- 5a: projection
- 6: surface of insulation cover layer
- 7: work to be chucked (wafer)
- 8: PG projection
- 9: wafer supporting plane
- 10: PG stud
- 11: terminal hole

## Claims

1. A wafer supporting device wherein a chuck electrode is formed in a predetermined pattern on a surface of an insulation substrate and said chuck electrode is covered by an insulation cover layer made of PBN or C-PBN, **characterized in that** said insulation cover layer has an uneven surface with projections covering projections of said chuck electrode, top surfaces of said projections being formed flush with each other to define a wafer supporting plane.

2. A wafer supporting device according to claim 1 wherein said chuck electrode has an uneven surface, and said uneven surface of said insulation cover layer is formed in correspondence with said uneven surface of said chuck electrode pattern.

3. A wafer supporting device according to claim 1 wherein a plurality of projections are formed in a dotted pattern with gaps therebetween on the surface of said chuck electrode.
